Europäisches Patentamt

European Patent Office

Office européen des brevets

(11) Numéro de publication: **0 327 445**
**A1**

(12) **DEMANDE DE BREVET EUROPEEN**

(21) Numéro de dépôt: **89400264.1**

(22) Date de dépôt: **31.01.89**

(51) Int. Cl.⁴: **G 06 F 7/544**
**H 03 H 17/02**

(30) Priorité: **02.02.88 FR 8801193**

(43) Date de publication de la demande:
**09.08.89 Bulletin 89/32**

(84) Etats contractants désignés: **DE GB IT NL**

(71) Demandeur: **ETAT FRANCAIS représenté par le
Ministère des Postes, des Télécommunications et de
l'Espace
(Centre National d'Etudes des Télécommunications)
38-40 rue du Général Leclerc
F-92131 Issy-les-Moulineaux (FR)**

(72) Inventeur: **Duhamel, Pierre
97, avenue de Verdun
F-92130 Issy les Moulineaux (FR)**

**Mou, Zhijian
37, boulevard Jourdan
F-75690 Paris Cédex 14 (FR)**

**Cand, Michel
9 Résidence Charvinière
F-38330 Saint Ismier (FR)**

(74) Mandataire: **Mongrédien, André et al
c/o BREVATOME 25, rue de Ponthieu
F-75008 Paris (FR)**

(54) Multiplieur numérique généralisé et filtre numérique mettant en oeuvre ce multiplieur.

㊗ Multiplieur numérique généralisé et filtre numérique le mettant en oeuvre.

Le multiplieur de l'invention comprend N registres à décalage ($RD_0$, ..., $RD_{N-1}$) contenant les mots $x_i$ sur B bits, N additionneurs conditionnels ($AdC_0$, ..., $AdC_{N-1}$) ajoutant chacun à la somme partielle qu'ils reçoivent un coefficient constant ($a_i$), conditionnellement à la valeur du bit ($x_{i,j}$) qu'ils reçoivent en provenance du registre associé ($RD_i$), et un additionneur-accumulateur (AdAc). Le filtre numérique utilisant un tel multiplieur comprend en outre un registre d'entrée, mots parallèles.

Application au filtrage numérique.

FIG. 12

EP 0 327 445 A1

**Description**

**MULTIPLIEUR NUMERIQUE GENERALISE ET FILTRE NUMERIQUE METTANT EN OEUVRE CE MULTIPLIEUR.**

La présente invention a pour objet un multiplieur numérique généralisé et un filtre numérique mettant en oeuvre ce multiplieur. Elle trouve une application en traitement numérique de signal, dans le calcul de quantités appelées "produits scalaires" (ou parfois "produits internes") de la forme:

$$P = \sum_{i=0}^{N-1} a_i x_i \qquad (1)$$

Dans cette expression, l'indice i désigne un rang, les termes $x_i$ représentent un ensemble de N signaux variables et les termes $a_i$ un ensemble de N coefficients déterminés, constants.

On rencontre de tels produits notamment en filtrage numérique.

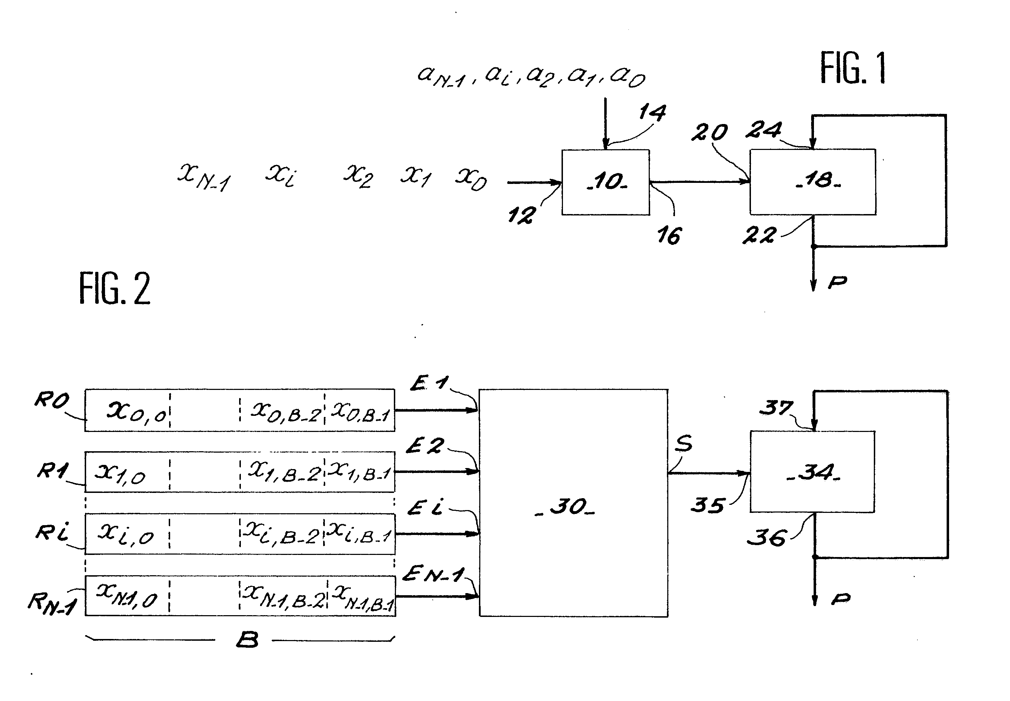

Pour calculer la quantité définie par la relation (1), on utilise parfois un circuit qui est schématisé sur la figure 1. Un multiplieur 10 reçoit, sur une première entrée 12, successivement les $x_i$ et, sur une seconde entrée 14, successivement les $a_i$. Le multiplieur délivre, sur sa sortie 16, l'un après l'autre, les produits $a_i x_i$. Un accumulateur 18 possède une première et une seconde entrées 20 et 24 et une sortie 22 bouclée sur la seconde entrée 24. Dès lors, l'accumulateur délivre, après N coups d'horloge (si i prend toutes les valeurs entières allant de 0 à N-1) le produit P recherché.

Un autre manière de réaliser cette opération consiste à mettre en oeuvre une technique appelée "arithmétique distribuée". Elle consiste d'abord à décomposer les termes $x_i$ en leurs B éléments binaires :

$$x_i = \sum_{j=0}^{B-1} x_{ij} . 2^j \qquad (2)$$

où j est un indice allant de 0 (élément binaire de plus faible poids) à B-1 (élément binaire de plus fort poids).

Cette décomposition, reportée dans l'équation 1, fait apparaître une double sommation :

$$P = \sum_{i=0}^{N-1} \left( a_i \sum_{j=0}^{B-1} x_{ij} 2^j \right)$$

Dans cette opération, on peut inverser l'ordre des sommations et écrire:

$$P = \sum_{j=0}^{B-1} \left( \sum_{i=0}^{N-1} a_i x_{ij} \right) 2^j \qquad (3)$$

Les éléments binaires $x_{ij}$ pouvant prendre les valeurs 0 ou 1, chaque produit $a_i x_{ij} 2$, pour j donné, est égal soit à 0 soit à $a_i 2$. La somme $f_j$ de N tels produits est la somme de N termes dont chacun peut prendre deux valeurs. Cette somme peut donc prendre $2^N$ valeurs différentes. L'ensemble de ces $2^N$ valeurs est déterminé et peut être calculé d'avance puisque les $a_i$ sont eux-mêmes déterminés et connus.

Ainsi, le terme entre parenthèses de l'équation (3) est-il égal à l'un des termes de cet ensemble de valeurs, terme qui est défini par le jeu des N éléments binaires $x_{ij}$ où le rang j est fixe et le rang i variable de 0 à N-1.

Dès lors, un multiplieur mettant en oeuvre cette technique se présente sous la forme représentée sur la figure 2.

Des registres à décalage $R_0$, $R_1$, $R_i$, $R_{N-1}$ à B cellules, contiennent chacun les B éléments binaires de chaque mot $x_i$. Une mémoire 30, de type ROM ("Read Only Memory") de 2 mots de $\underline{m}$ éléments binaires possède N entrées $E_1$, $E_2$,..., $E_i$, ..., $E_{N-1}$ reliées aux sorties respectives des N registres $R_i$. Dans cette mémoire sont rangées les $2^N$ valeurs possibles évoquées plus haut pour les produits partiels. La mémoire 30 possède une sortie S qui est reliée à un additionneur-accumulateur 34 à une première entrée 35, une sortie 36, et une seconde entrée 37. La sortie 36 est rebouclée sur la seconde entrée 37. Une horloge non représentée rythme le décalage dans les registres, la lecture de la mémoire et l'additionneur-soustracteur.

Lorsqu'après un coup d'horloge, un jeu de N éléments binaires $x_{ij}$ (j déterminé, i allant de 0 à N-1) est appliqué sur les entrées $E_1$, ..., $E_{N-1}$ de la mémoire, celle-ci se trouve adressée par ce jeu et délivre le produit $f_j$ correspondant. Il reste à faire la somme de ces produits partiels, ce qui est effectué par l'additionneur 34.

Dans ce qui précède, on a supposé, pour simplifier, que tous les produits à ajouter étaient positifs, autrement dit, qu'il n'y avait que des additions à effectuer. En pratique, les nombres considérés ont un signe. Il se posera donc une question supplémentaire qui est celle du signe des diverses quantités manipulées. Mais l'homme du métier sait résoudre cette question (utilisation du code binaire en complément à 2) et il n'est donc pas nécessaire ici d'entrer dans le détail de cette question accessoire.

Une autre technique pour réaliser un produit scalaire est l'utilisation d'un circuit appelé "multiplieur parallèle".

S'agissant de multiplier un terme $a$ par un terme $x$ pour obtenir le produit partiel Pr, on peut, comme plus haut pour la relation (3), décomposer x en ses éléments binaires :

$$x = \sum_{j=0}^{B-1} (X_j)2^j \quad (3')$$

Le produit ax se met donc sous la forme :

$$Pr = \sum_{j=0}^{B-1} (X_j)a2^j \quad (4)$$

Le terme $X_j$ est un élément binaire égal à 0 ou 1.
Le terme $a2^j$ est un mot décalé de j positions.

L'expression (4) représente donc, en termes de matériel, l'addition au résultat partiel obtenu avant le rang j d'un mot $a$ décalé de j positions, conditionnellement à la valeur de l'élément binaire $A_j$ de rang j de la représentation binaire du terme a :

$$a = \sum_{j=0}^{B-1} A_j 2^j$$

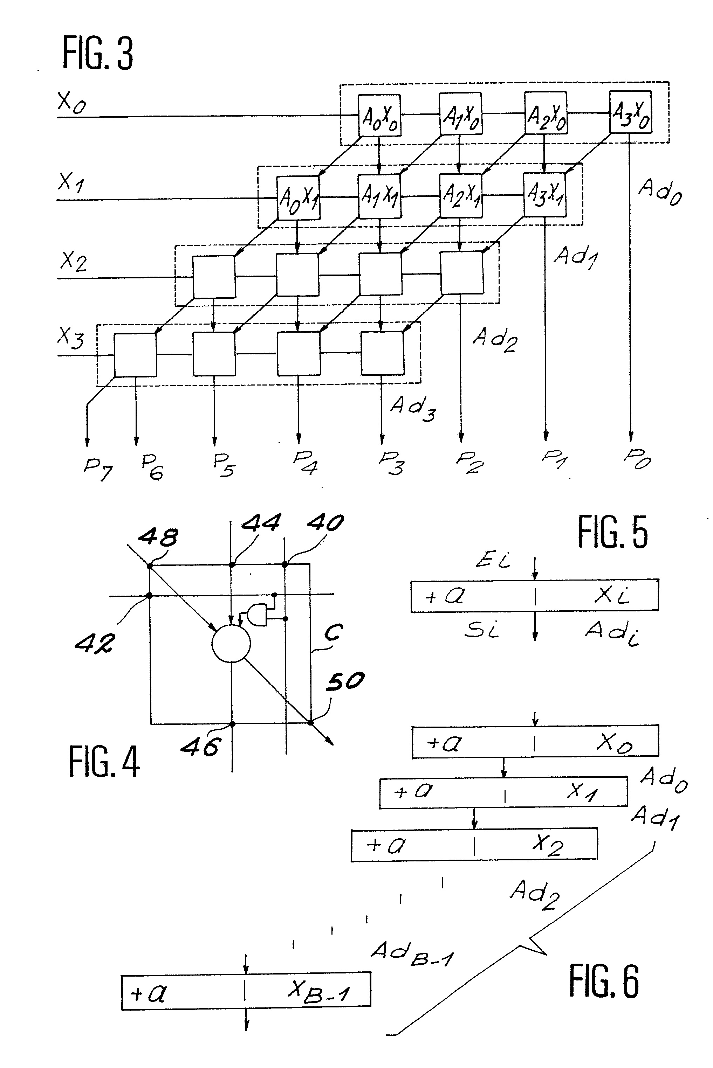

Le schéma général d'un multiplieur parallèle pour des mots de 4 éléments binaires (ce que correspond dans la présente notation à N = 4) est représenté en figure 3.

Il comprend quatre additionneurs $Ad_0$, $Ad_1$, $Ad_2$ et $Ad_3$, chacun constitué par quatre cellules dont la structure est donnée sur la figure 4. Une cellule C comprend une première entrée 40 recevant un premier élément binaire, une seconde entrée 42 recevant un second élément binaire, une entrée 44 de retenue, une sortie 46 de retenue, une entrée 48 de propagation, une sortie 50 de propagation.

Les quatre cellules du premier additionneur $Ad_0$ effectuent respectivement les produits $A_0X_0$, $A_1X_0$, $A_2X_0$ et $A_3X_0$.

L'additionneur $Ad_1$ est décalé d'une position vers la gauche par rapport à l'additionneur $Ad_0$. Ses quatre cellules effectuent l'opération qui consiste à ajouter aux résultats délivrés par les quatre cellules de l'additionneur $Ad_0$, le mot $a$ ($A_3A_2A_1A_0$) décalé d'une position vers la gauche.

Finalement, le multiplieur possède huit sorties $P_0$ à $P_7$ sur lesquelles on trouve le résultat du produit de $a$ par $x$.

Chaque additionneur du multiplieur de la figure 3 peut être représenté schématiquement comme indiqué sur la figure 5 : un additionneur conditionel $Ad_i$ comprend une entrée $E_i$ recevant un mot auquel il ajoute le mot $\underline{a}$, conditionnellement à la valeur de l'élément binaire $X_i$ ; il délivre le résultat sur une sortie $S_i$.

Le schéma bloc d'un multiplieur parallèle est donc celui de la figure 6 avec B additionneurs conditionnels $Ad_0$, $Ad_1$,..., $Ad_{B-1}$.

En pratique, comme le nombre $a$ est connu, il s'agit de réaliser une addition dont l'un des opérandes (a) est connu. Cette constante se décompose en éléments binaires ($A_0$, $A_1$,..., $A_{B-1}$) égaux à 0 ou 1, selon une distribution connue. On peut donc réaliser par avance des additionneurs spécialisés pour chaque constante. Pour cela, il suffit d'adapter une cellule classique, telle que celle de la figure 4, pour la spécialiser à l'ajout d'un élément binaire égal à 0 ou à 1. La complexité du circuit se trouve alors réduite d'un facteur presque égal à 2.

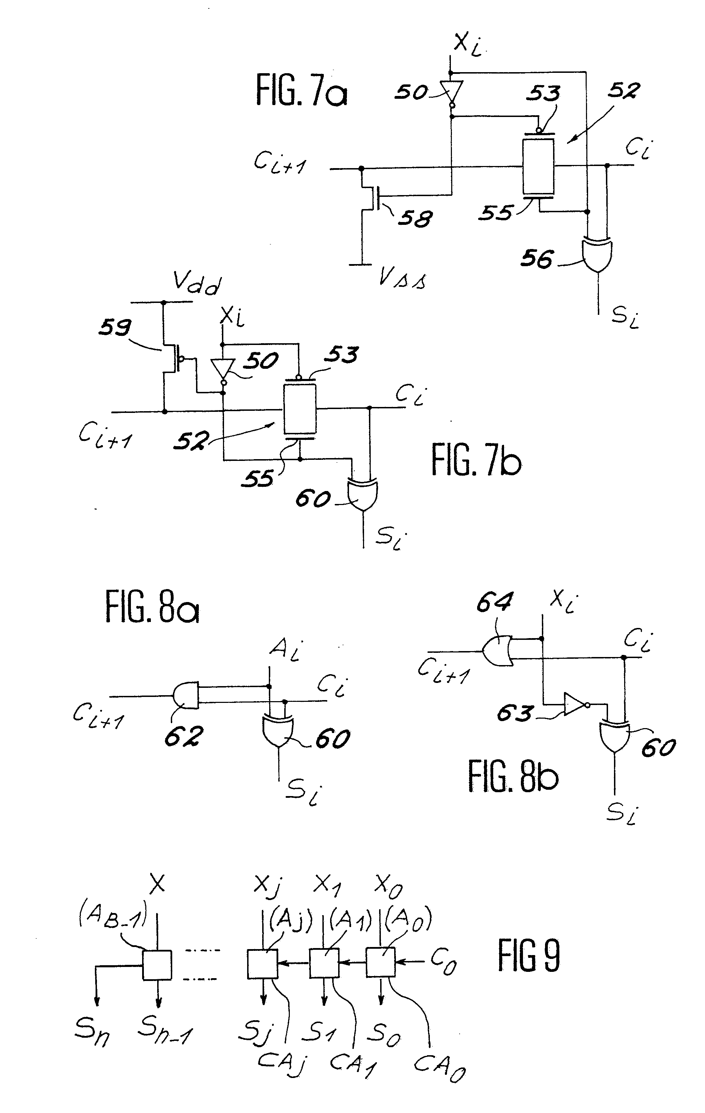

La demande de brevet français 86.13222 déposée le 22 septembre 1986 décrit deux cellules d'addition spécialisées qui sont de ce type. Les figures 7a et 7b annexées les illustrent. La cellule d'addition de la figure 7a comprend une entrée de données $X_i$ recevant un élément binaire, un inverseur 50, une entrée de retenue $C_i$, un interrupteur 52 constitué par un transistor CMOS à canal P référencé 53 et un transistor CMOS à canal N référencé 55, une porte OU-exclusif 56 ayant une sortie $S_i$, un transistor 58 de type CMOS à canal N recevant un potentiel fixe $V_{ss}$ correspondant à l'état logique "1" et délivrant un signal de sortie de retenue $C_{i+1}$. Les transistor 53 et 55 reçoivent respectivement sur leurs grilles les bits $\overline{X}_i$ et $X_i$. Le transistor 58 est commandé par le complément $\overline{A}_i$ du bit $A_i$.

La cellule de la figure 7b comprend les mêmes éléments, à la différence que les transistors 53 et 55 reçoivent non plus $\overline{X}_i$ et $X_i$ mais $X_i$ et $\overline{X}_i$ et que le transistor 59 de type CMOS à canal P reçoit un potentiel fixe $V_{dd}$ correspondent à l'état logique "0".

Les cellules d'addition des figures 7a et 7b ont été représentées sous forme de portes logiques sur les figures 8a et 8b. La cellule d'addition de la figure 8a se réduit ainsi à deux portes logiques : une porte OU-exclusif 60 et une porte ET 62. Chaque porte reçoit sur une entrée le bit $X_i$ et sur l'autre entrée le bit de retenue $C_i$. La porte ET 62 délivre le bit de retenue $C_{i+1}$ et la porte OU-exclusif 60 le bit de somme $S_i$.

La cellule d'addition représentée sur la figure 8b se compose d'un inverseur 63, d'une porte OU-exclusif 60 et d'une porte OU 64. L'inverseur 63 reçoit le bit $X_i$. Sa sortie est reliée à l'une des entrées de la porte OU-exclusif 60, l'autre entrée recevant le bit de retenue $C_i$. La sortie de la porte OU-exclusif 60 délivre la somme $S_i$. Enfin, la porte OU 54 reçoit sur ses entrées les bits $X_i$ et $C_i$ et délivre le bit de retenue $C_{i+1}$.

Un additionneur complet se compose ainsi de cellules d'addition telles que représentées sur les figure 7a et 7b (ou 8a et 8b). Ces cellules d'addition sont reliées en série, c'est-à-dire que la sortie de retenue d'une cellule d'addition est reliée à l'entrée de retenue de la cellule d'addition suivante.

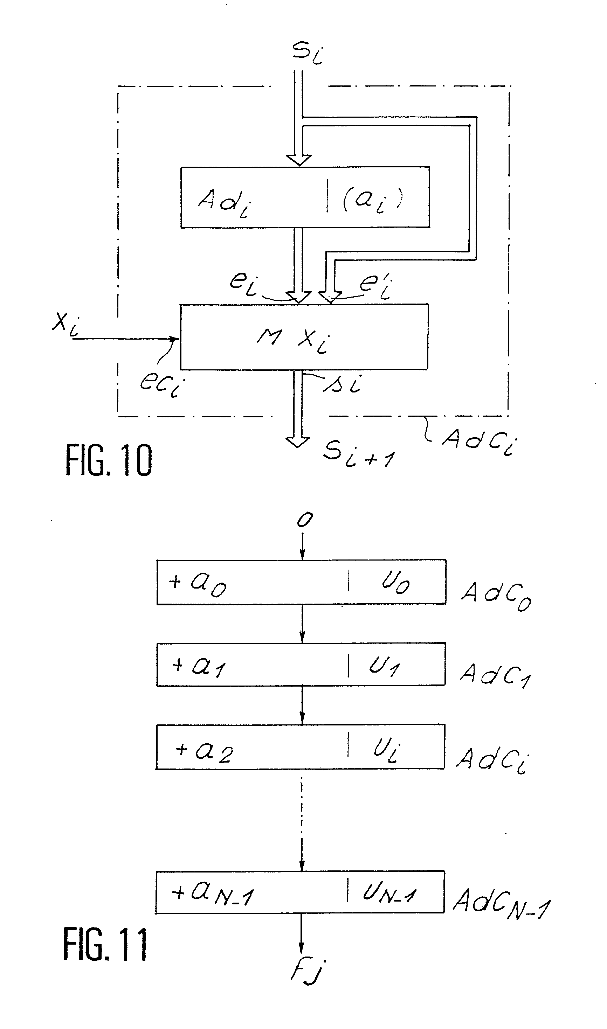

On a représenté schématiquement sur la figure 9 un additionneur de ce type. Il comprend un ensemble de cellules d'addition CA₀, CA₁, CAᵢ, CA_{B-1} reliées en série. Chaque cellule d'addition reçoit un bit Xⱼ et possède une structure spécifique, fonction de la valeur logique du bit Aⱼ de l'opérande fixe et connu A_{B-1}, ..., A₁, A₀.

Pour obtenir un additionneur conditionnel à partir de cet additionneur, il fait ajouter un multiplexeur comme représenté sur la figure 10. Sur cette figure, l'additionneur conditionnel de rang i, soit AdCᵢ est constitué d'un additionneur Adᵢ conforme à celui de la figure 9 et recevant une somme partielle Sᵢ, d'un multiplexeur MXᵢ à deux entrées, l'une eᵢ reliée à la sortie de l'additionneur Adᵢ et l'autre e'ᵢ à l'entrée de ce même additionneur. Ce multiplexeur possède une entrée de commande ecᵢ qui reçoit le bit Xᵢ, qui est un bit conditionnel, et une sortie sᵢ qui délivre une nouvelle somme Sᵢ₊₁.

Si le bit conditionnel Xᵢ est à "0", le multiplexeur délivre directement Sᵢ en "court-circuitant" l'additionneur Adᵢ. On a alors Sᵢ₊₁=Sᵢ.

Si le bit conditionnel Xᵢ est à "1", l'addition effectuée dans Adᵢ est prise en compte et une nouvelle somme Sᵢ₊₁, différente de Sᵢ est obtenue (Sᵢ₊₁=Sᵢ+aᵢ).

Un tel additionneur peut être utilisé quel que soit le signe des deux opérandes. Dans le cas où l'opérande fixe est négatif, il suffit de choisir les cellules d'addition pour que cet opérande soit représenté en code complément à 2.

L'additionneur peut également être utilisé comme soustracteur. Il suffit dans ce cas d'échanger les cellules d'addition des premier et second types, ce qui revient, comme dans le cas précédent, à additionner le complément de l'opérande fixe, et de câbler le bit de retenue C₀ à la valeur logique "1", ce que revient à additionner l'opérande fixe -B à l'opérande variable A.

Un multiplieur parallèle, tel que celui de la figure 6, constitué d'additionneurs tels que celui de la figure 10 traitant un opérande fixe, permet donc d'obtenir un produit du type ax. Pour obtenir une quantité de la forme :

$$P = \sum_{i=0}^{N-1} a_i x_i$$

il faut une pluralité de N multiplieurs de ce type, chacun dédié à l'un des N opérandes fixes a₀, ..., a_{N-1} et recevant chacun les N termes X₀, ..., X_{N-1}. Un additionneur final donnera le produit scalaire P.

Bien que donnant satisfaction à certains égards, ces dispositifs, qu'ils soient à base d'arithmétique distribuée ou de multiplieurs parallèles à opérande fixe, sont complexes et de mise en oeuvre lourde. Ainsi, la technique de l'arithmtique distribuée, si elle est bien adaptée lorsque la longueur des produits scalaires est faible (typiquement inférieure à 10) devient lourde au-delà, car la taille de la mémoire croît exponentiellement avec la longueur. Pour des longueurs importantes on est obligé de séparer la mémoire en plusieurs sous-mémoires, dont les résultats partiels doivent ensuite être additionnés.

En ce que concerne le circuit intégré que réalisera les opérations, cela fait perdre une grande partie de la régularité du dessin de gravure.

Pour ce que est de la solution à multiplieurs parallèles, la gestion de l'arrivée des différentes coefficients est lourde et les connexions entre éléments ont des longueurs prohibitives sur le circuit intégré.

La présente invention a justement pour objet un multiplieur qui évite ces inconvénients.

A cette fin, elle préconise un additionneur dont la structure permet de simplifier la partie de contrôle : il n'y a plus à gérer l'arrivée des coefficients (par des bus, des mémoires, des séquenceurs, ...) et d'éviter les connexions locales, ou du moins de réduire leur longueur. Le dessin du circuit intégré correspondant est très répétitif, à partir d'un nombre de cellules de base très limité. La taille de ce dessin croît avec N mais seulement de manière linéaire avec N. De plus, le débit d'un tel dispositif peut être adapté en introduisant le nombre d'étages de "pipe-line" nécessaire.

L'invention parvient à ce résultat grâce à l'utilisation d'un dispositif à entrée mot-parallèle, bit-série, et d'un circuit multiplieur original que effectue un traitement en parallèle, le traitement correspondant au bit-série étant effectué dans un accumulateur de sortie.

De façon plus précise, la présente invention a pour objet un multiplieur numérique généralisé apte à calculer une quantité P de la forme :

$$P = \sum_{i=0}^{N-1} a_i x_i$$

où les termes aᵢ sont des mots binaires correspondant à N coefficients déterminés et les termes xᵢ sont des mots binaires de B bits correspondant à N signaux variables, ce multiplieur numérique généralisé étant caractérisé par le fait qu'il comprend :
- N registres à décalage à entrée mot-parallèle sur les B bits et à sortie bits-série, le ième registre contenant les B bits du mot binaire xᵢ,
- N additionneurs conditionnels munis chacun d'une entrée de données, d'une sortie de données et d'une entrée de commande, l'entrée de commande du ième additionneur conditionnel étant reliée à la sortie du ième registre à décalage, l'entrée de données et la sortie de données du ième additionneur conditionnel étant reliées respectivement à la sortie de données du (i-1)ième additionneur conditionnel et à l'entrée de données du (i-1)ième additionneur conditionnel, ledit ième additionneur conditionnel incorporant le terme aᵢ et ajoutant celui-ci au signal reçu sur son entrée de données, conditionnellement à la valeur de jième bit xᵢⱼ du mot xᵢ, ce bit étant reçu sur l'entrée de commande,
- un additionneur-accumulateur muni d'une première et d'une seconde entrées de données, la première entrée de données étant reliée à la sortie du Nième additionneur conditionnel, ledit additionneur-accumulateur comprenant en outre une sortie de données reliée à la seconde entrée de données dudit additionneur-accumulateur après décalage d'une position des bits,

- un circuit d'horloge pour commande en parallèle le décalage des B bits contenus dans les N registres série et faire passer le rang j de 0 à B-1,

- la quantité P recherchée étant délivrée sur la sortie de données de l'additionneur-accumulateur tous les B coups d'horloge.

La présente invention a également pour objet un filtre numérique non récursif, mettant en oeuvre le multiplieur qui vient d'être défini, pour le calcul d'une expression de la forme :

$$P = \sum_{i=0}^{N-1} a_i x_{n-i}$$

caractérisé par le fait qu'il comprend :

- un registre général d'entrée à N registres de B bits, chaque registre ayant une entrée parallèle sur B bits et une première sortie parallèle sur B bits, ces registres étant reliés les uns aux autres en parallèle par ces entrées-sorties parallèles, chaque registre ayant en outre une seconde sortie parallèle,

- un multiplieur numérique conforme à la définition donnée plus haut avec un ensemble de registres à décalage et une batterie d'additionneurs conditionnels, multiplieur dans lequel l'entrée mot-parallèle du ième registre à décalage est reliée à la seconde sortie du registre de même rang $i$.

De toute façon, les caractéristiques et avantages de l'invention apparaîtront mieux à la lumière de la description qui va suivre. Cette description porte sur des exemples de réalisation donnés à titre explicatif et nullement limitatif et se réfère aux dessins annexés, qui font suite aux figures 1 à 10 déjà décrites et sur lesquels :

- la figure 11 représente un ensemble d'additionneurs conditionnels selon l'invention,

- la figure 12 représente le schéma bloc multiplieur de l'invention,

- la figure 13 montre un filtre numérique conforme à l'invention,

- la figure 14 montre un filtre à structure parallèle.

Revenant sur le problème à résoudre, qui est le calcul du produit :

$$P = \sum_{i=0}^{N-1} a_i x_i \qquad (1)$$

il a été montré plus haut que ce produit pouvait se mettre sous la forme :

$$P = \sum_{j=0}^{B-1} \left( \sum_{i=0}^{N-1} a_i x_{ij} \right) 2^j \qquad (2)$$

L'expression entre parenthèses peut s'écrire :

$$f_j = \sum_{i=0}^{N-1} a_i u_i \qquad (5)$$

où chacune des variables $u_i$ peut prendre deux valeurs différentes. La fonction $f_j$ peut donc prendre $2^N$ valeurs différentes selon les valeurs des N coefficients $u_i$ qui la composent, ce qui est le fondement même de l'arithmétique distribuée évoquée plus haut.

Cette fonction $f_j$ est calculée, selon l'invention, par un ensemble d'additionneurs conditionnels et non pas à l'aide d'une mémoire ROM comme dans l'art antérieur. Un tel ensemble est représenté sur la figure 11 avec la convention déjà utilisée à propos de la figure 5 déjà décrite : un additionneur conditionnel de rang i, noté $AdC_i$, ajoute $a_i$ au nombre qu'il reçoit, conditionnellement à la valeur de la variable $u_i$.

L'ensemble représenté comprend N additionneurs de ce type, soit $AdC_0$, ..., $AdC_{N-1}$ et délivre finalement la fonction $f_j$ définie par la relation (5).

Un tel circuit peut rappeler le multiplieur parallèle de l'art antérieur, tel qu'il a été illustré sur la figure 6. Mais deux différences essentielles doivent être soulignées :

- dans l'additionneur de l'invention, les constantes à ajouter à chaque étage sont différentes d'un étage à l'autre. C'est la raison pour laquelle les inventeurs qualifient ce multiplieur de "généralisé" par opposition aux multiplieurs de l'art antérieur qui sont, en quelque sorte spécialisés, puisque la constante à ajouter est toujours la même,

- il n'y a pas de décalage d'une position d'un étage à l'autre (correspondant à la multiplication par 2).

Cependant, du fait de la similitude de structure entre le multiplieur généralisé de l'invention et le multiplieur parallèle connu, toutes les variantes qui ont été développées sur ce dernier pour en améliorer la vitesse de fonctionnement, sont applicables au multiplieur généralisé de l'invention.

Le multiplieur généralisé de l'invention peut prendre deux formes différentes, selon que l'on utilise des additionneurs conditionnels spécialisés dans une addition déterminée, comme exposé plus haut à propos de la figure 9, ou que l'on utilise un moyen particulier comme un point mémoire chargé avant la mise en marche du dispositif par la valeur appropriée.

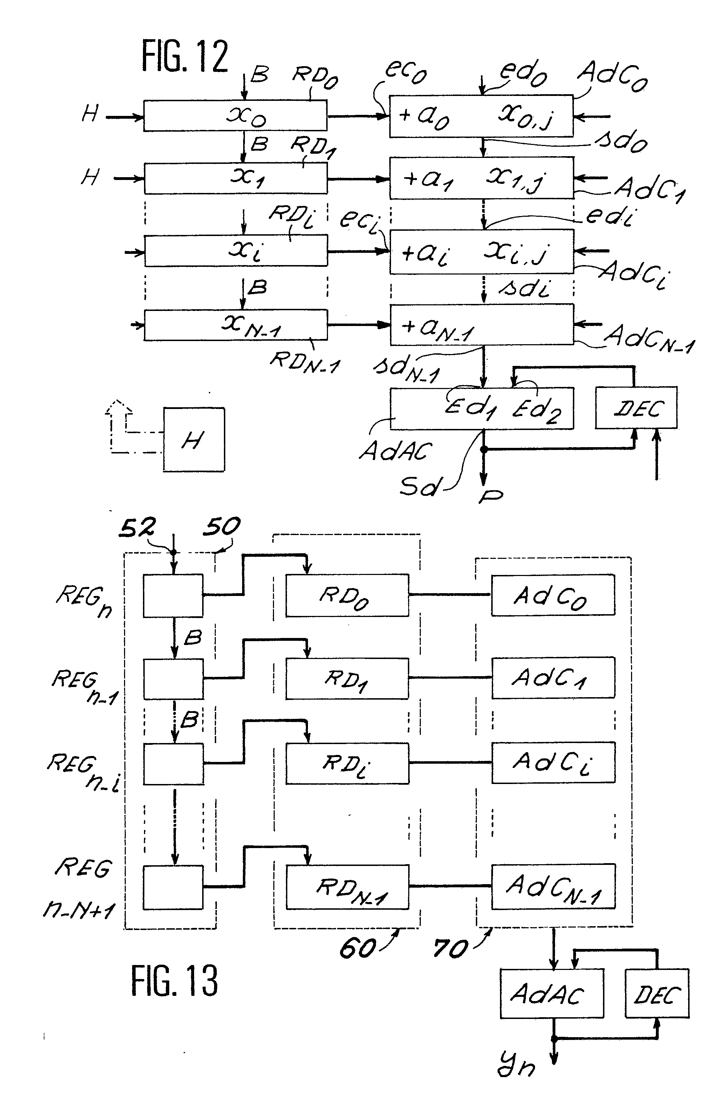

Le premier mode de réalisation est plus compact que le second, mais il reste spécialisé dans un calcul particulier. Il est représenté sur la figure 12.

Tel que représenté, le multiplieur numérique généralisé comprend :

- N registres à décalage $RD_0$, $RD_1$, ..., $RD_i$, $RD_{N-1}$ à entrée mot-parallèle sur B bits et à sortie bits sirie, le ième registre $RD_i$ contenant les B bits du mot binaire $x_i$,

- N additionneurs conditionnels $AdC_0$, $AdC_1$, ..., $AdC_i$, ..., $AdC_{N-1}$, le ième additionneur possédant une entrée de données $ed_i$, d'une sortie de données $sd_i$ et d'une entrée de commande $ec_i$, l'entrée de commande $ec_i$ du ième additionneur conditionnel $AdC_i$ étant reliée à la sortie du ième registre à décalage $RD_i$, l'entrée de données $ed_i$ et la sortie de données $sd_i$ du ième additionneur conditionnel étant reliées respectivement à la sortie de données du (i-1)ième additionneur conditionnel et à l'entrée de données du (i+1)ième additionneur conditionnel,

- un additionneur-accumulateur AdAc muni d'une première et d'une seconde entrées de données $Ed_1$, $Ed_2$, la première entrée de données $Ed_1$ étant reliée à la sortie $sd_{N-1}$ de l'additionneur conditionnel, de rang N-1, l'additionneur-accumulateur AdAc comprenant en outre une sortie de données Sd bouclée sur la seconde entrée de données $Ed_2$ de ce même additionneur-accumulateur, mais après décalage d'une position, (vers la droite si les bits contenus dans les registres $RD_i$ ont leur poids faible en tête, et vers la gauche dans le cas contraire), ce décalage étant symbolisé sur la figure 12 par un bloc référence DEC,

- un circuit d'horloge H pour commander le décalage des bits contenus dans les N registres $RD_0$, ..., $RD_{N-1}$.

Le fonctionnement de ce multiplieur est le suivant. Les registres à décalage $RD_0$, ..., $RD_i$, ..., $RD_{N-1}$ contiennent les mots $x_0$, ..., $x_i$, ..., $x_{N-1}$. A chaque coup d'horloge, les bits de ces mots sont décalés vers la droite d'une position. Après j coups d'horloge on trouve donc, sur les N sorties de ces registres, les N bits de rang j des mots $x_i$, soit $x_{0,j}$, $x_{1,j}$, ..., $x_{i,j}$, ..., $x_{N-1,j}$.

Les additionneurs conditionnels $AdC_0$, ..., $AdC_i$, ..., $AdC_{N-1}$ sont aptes à ajouter un mot, respectivement $a_0$, $a_1$, ..., $a_i$, ..., $a_{N-1}$, au mot qu'ils reçoivent sur leur entrée de donnée, conditionnellement à la valeur des bits $x_{0,j}$, $x_{1,j}$, ..., $x_{i,j}$, ..., $x_{N-1,j}$, qu'ils reçoivent sur leur entrée de commande.

Le dernier additionneur conditionnel $AdC_{N-1}$ délivre finalement la somme $f_j$ :

$$f_j = \sum_{i=0}^{N-1} a_i x_{i,j} \quad (5')$$

L'additionneur-accumulateur AdAc ajoute à chaque $f_j$ le $f_{j-1}$ obtenu précédemment mais décalé vers la droite d'une position (ce que correspond à une division par 2). Après N additions de ce type, c'est-à-dire après B coups d'horloge, on obtient :

$$\sum_{j=0}^{B-1} f_j 2^j \quad (2')$$

c'est-à-dire le produit scalaire P recherché (cf. relation (1)).

Dans le circuit de la figure 12, chaque additionneur conditionnel peut être constitué, comme représenté sur la figure 10.

Le traitement du bit de signe s'effectue, dans tous les cas, de la même manière que pour l'arithmétique distribuée : soustraction du résultat partiel $f(x_{0,B-1}, x_{1,B-1}, ..., x_{N-1,B-1})$ du contenu de l'accumulateur dans le cas de l'utilisation du code complément à 2.

Le multiplieur que vient d'être décrit peut être utilisé pour réaliser un filtre numérique non récursif.

On sait qu'un tel filtre est décrit par l'équation :

$$Y_n = \sum_{i=0}^{N-1} a_i x_{n-i} \quad (6)$$

où les $a_i$ sont les coefficients du filtre, les $x_{n-i}$ des mots de rang n-i où n est un indice fixe et i un indice de sommation. En d'autre termes, le filtrage numérique d'un signal échantillonné est un calcul d'une somme d'échantillons retardés et pondérés.

Il est aisé de reconnaître dans la relation (6) un cas particulier de la relation (1). Le filtrage numérique non récursif de la relation (6) revient donc au calcul d'un produit scalaire où les $x_i$ seraient des $x_{n-i}$.

Un multiplieur adapté au filtrage numérique aura la même structure que dans le mode de réalisation de la figure 12, mais les mots numériques traités auront une signification un peu différente : dans le registre à décalage $RD_i$ on trouvera le mot $x_{n-i}$, avec ses B bits $x_{n-i,B-1}$, ..., $x_{n-i,1}$, ... $x_{n-i,0}$ ; dans les additionneurs conditionnels on trouvera les coefficients du filtre $a_0$, $a_1$, ..., $a_i$, ..., $a_{n-1}$.

La sortie du multiplieur donnera alors la composante de rang n du signal filtré, soit $y_n$.

Pour obtenir la composante suivant $y_{n+1}$, il faudra traiter des échantillons $x_{n+1}$, $x_n$, ..., $x_{n-i+1}$, c'est-à-dire décaler d'un rang le jeu des échantillons. Un filtre complet doit donc comporter un registre supplémentaire capable de recevoir N mots représentant les N échantillons nécessaires au filtrage. C'est ce qui est représenté sur la figure 13.

Le filtre représenté sur cette figure comprend un registre général d'entrée 50, un ensemble de registres à décalage 60, une batterie d'additionneurs-conditionnels 70, un additionneur-accumulateur AdAc.

Le registre d'entrée 50 comprend N registres $REG_n$, $REG_{n-1}$, ..., $REG_{n-i}$, ..., $REG_{n-N-1}$. Tous ces registres sont à B bits et sont chargés par des mots de B bits appliqués en parallèle. L'ensemble de ces N mots représente ainsi une "photographie" du signal échantillonné, lequel est appliqué sur une entrée 52.

Chacun des registres REG charge un des registres à décalage du bloc 60, les B bits étant appliqués en parallèle. Chaque mot est ensuite lu par décalage, c'est-à-dire bit à bit pour le traitement par la bloc 70.

Ainsi, lorsque le dernier mot $x_n$ a été introduit dans l'ensemble 50, c'est-à-dire dans le premier registre $REG_n$, le filtre peut calculer la composante $y_n$ de filtrage.

Pour préciser les fréquences de fonctionnement des diverses parties d'un tel filtre, on suppose que le bloc 50 travaille à une fréquence de signal $f_s$ (au niveau du mot), que le contenu de ce bloc est recopié à la fréquence $f_r$ dans le bloc 60 (fréquence de recopie), que les registres à décalage (au niveau du bit) du bloc 60 travaillent à la fréquence $f_c$ qui est la fréquence de calcul du bloc 70.

Les bits constituant la composante $y_n$ seront donc obtenus à la cadence $Bf_c$.

Un dispositif caractérisé par :
$f_r = f_s$
$f_s = f_c/B$
réalisera un filtrage du type RIF (Réponse Impulsionnelle Finie ou FIR en terminologie anglo-saxonne), tel que décrit par l'équation (6).

Typiquement, on pourra avoir, avec des technologies courantes $f_c = 25$ MHz.

Pour B = 8 bits, un dispositif pourra donc effectuer un filtrage à une cadence de 3 MHz.

Il est possible de réaliser un filtre avec une sortie sous-échantillonnée d'un facteur M, c'est-à-dire dans lequel on ne calcule pas tous les échantillons, mais un échantillon sur M, soit $y_{n+M}$, $y_{n+2M}$, ...

Les paramètres suivants peuvent être choisis :
$f_r = f_s/M$
$f_s = Mf_c/B$

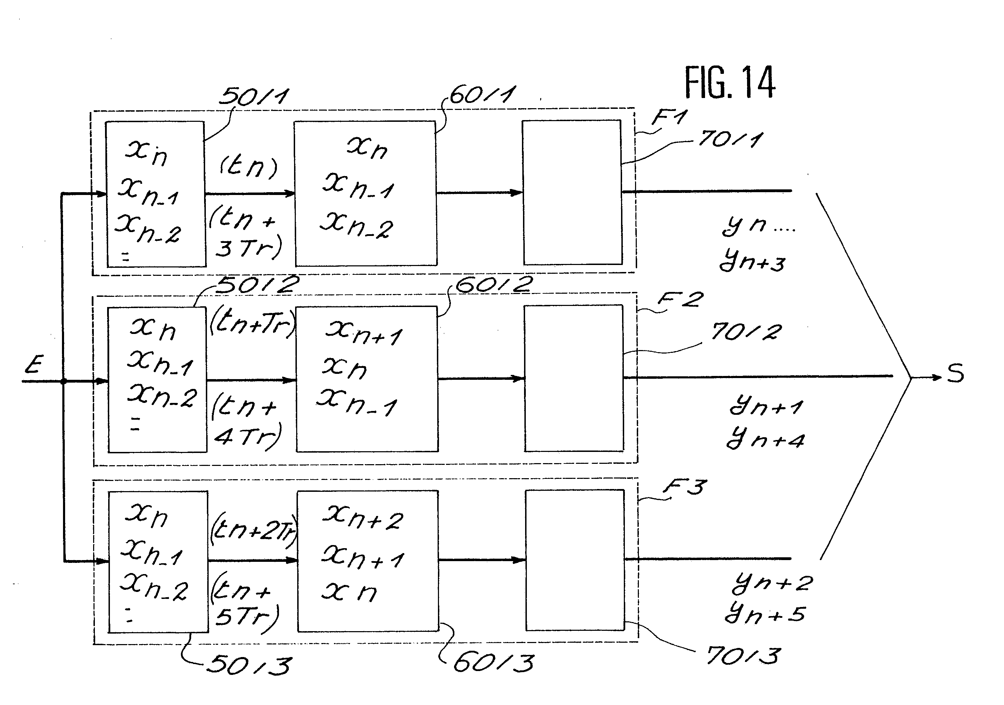

Le filtre de l'invention se prête à une structure parallèle comme illustré sur la figure 14. Le dispositif représenté comprend trois filtres $F_1$, $F_2$ et $F_3$. Chaque filtre comporte, comme la structure illustrée sur la figure 13, un bloc 50 à décalage par mot, un bloc 60 à décalage par bit et un bloc 70 de calcul. Ces blocs sont affectés des indices 1, 2 ou 3 pour les filtres $F_1$, $F_2$ et $F_3$.

Les filtres $F_1$, $F_2$, et $F_3$ ont une même entrée E, de sorte que tous les échantillons $x_n$, $x_{n-1}$, $x_{n-2}$, etc. sont appliqués aux registres 50/1, 50/2, 50/3. Ceux-ci contiennent donc à un instant donné, les mêmes mots. Mais les instants de recopie diffèrent dans les blocs 60/1, 60/2 et 60/3. Lorsque, à l'instant $t_0$, les registres 50/1, 50/2, 50/3 contiennent la suite $x_n$, $x_{n-1}$, $x_{n-2}$, etc. (c'est-à-dire à l'instant correspondant aux notations de la figure 14) la recopie du registre 50/1 s'effectue dans le registre 60/1.

La recopie dans le registre 60/2 ne s'effectuera qu'après un intervalle de temps T, c'est-à-dire à $t_0 + T$, si T désigne la période d'échantillonnage correspondant à la fréquence du signal $f_s$. En d'autres termes, la recopie dans 60/2 se produira lorsque l'échantillon $x_{n+1}$ aura été introduit dans les registres d'entrée 50/1, 50/2 et 50/3.

De même, à l'instant $t_0 + 2T$ s'effectuera la recopie des échantillons dans le bloc 60/3, c'est-à-dire à un instant où le dernier échantillon entré sera $x_{n+2}$.

Dans une telle structure, le bloc de calcul 70/1 délivrera un coefficient de filtrage $y_n$. Après un intervalle T, le bloc 70/2 délivrera le coefficient $y_{n+1}$

et après un nouvel intervalle T, le bloc 70/3 délivrera le coefficient $y_{n+2}$.

Puis le bloc 70/1 délivrera un nouveau coefficient $y_{n+3}$, le bloc 70/2 le coefficient $y_{n+4}$, le bloc 70/3 le coefficient $y_{n+5}$, etc.

Tous ces coefficients seront réunis (grâce par exemple à une sortie 3 états) et formeront la suite continue des composantes de filtrage.

Naturellement, si la variante illustrée sur les figures 14 comprend trois filtres en parallèle, ce n'est qu'à titre explicatif et l'invention couvre tous les filtres à structures parallèle, quel que soit le nombre de sous-ensembles. D'une façon générale, on peut mettre en parallèle L filtres sous-échantillonnés dans un rapport M et travaillant à des instants de recopie décalés de Ts/L si Ts est la période correpondant à la fréquence de signal Fs.

Avec L = 2, on aura deux filters $F_1$ et $F_2$ et l'on pourra choisir pour chacun des filtres :
$f_r = f_s/2$
$f_s = 2f_c/B$

Pour $f_c = 24$MHz, B = 8 bits, on aura $f_s = 6$MHz et $f_r = 3$MHz.

Les phases des deux fréquences de recopies $f_r$ devront être différentes et décalées de $B/2f_c$.

On voit que, dans de tels dispositifs à structure parallèle, seule la partie 50 fonctionne à la fréquence de signal $f_s$. C'est donc cette partie qui limitera le débit possible par mise en parallèle de dispositifs. Toutes les autres fréquences sont de l'ordre de $f_c$.

Il est possible de choisir les fréquences $f_c$, $f_r$, $f_s$, de telle manière que les sommes $y_n$ soient sous-échantillonnées d'un facteur M fois moins que le facteur d'échantillonnage d'un dispositif.

Il est donc possible de réaliser des circuits identiques, tels que l'un d'entre eux engendre la fréquence $f_r$, et fournisse à son suivant un signal de synchronisation permettant à celui-ci d'engendrer sa propre fréquence $f_r$ déphasée, à charge pour ce deuxième dispositif de fournir à son suivant un autre signal de synchronisation, et ainsi de suite.

On peut récapituler les différents paramètres en jeu dans un filtre à structure parallèle comme il vient d'être décrit :
L : nombre de circuits à mettre en parallèle,
M : taux de sous-échantillonnage,
$f_c$ : fréquence de calcul,
$f_s$ : fréquence de signal,
$f_r$ : fréquence de recopie,
$E_{sync}$ : entrée de synchronisation,
$S_{sync}$ : sortie de synchronisation,
B : nombre de bits du signal d'entrée,
DS : $S_{sync}$-$E_{sync}$ = retard entre les signaux $f_r$ de deux circuits successifs.

Tous ces paramètres dépendent en fait de quatre données fondamentales $f_c$, $f_s$, M, B. On a alors :
$L = f_s/f_c \, B/M$,
$f_r = f_c/B$,
$DS = B/F_c.L = M/f_s$.

La première entrée de synchronisation (non connectée) indiquera une fréquence de recopie non décalée, DS indiquant le décalage avec le circuit suivant.

Le sous-ensemble [L, M, max($f_c$,$f_s$)], (B étant naturellement connu lors du dessin du circuit) fournit l'ensemble des paramètres permettant à la fois une génération des autres signaux la plus facile, et également une utilisation simple du circuit.

A titre d'exemple, on peut choisir le circuit suivant : $f_s = 50$ MHz, $f_c = 25$ MHz, $B = 8$, $M = 1$, $N = 40$.

On aura :

$L = 16$ circuits en parallèle,

$f_r = 3$ MHz,

$DS = 1/50$ MHz.

Du point de vue de la réalisation matérielle du circuit, chaque circuit comporte environ 30.000 transistors en technologie CMOS, et 3 niveaux de "pipe-line". Un tel circuit peut être utilisé comme filtre dans un MODEM ("modulateur-démodulateur") destiné aux satellites artificiels.

Un ensemble de 16 circuits identiques connectés de manière simple (entrées identiques, sorties identiques, commandes quasi-identiques) permet ainsi un filtrage numérique à 50 MHz de fréquence d'échantillonnage.

Il va de soi que les structures qui viennent d'être décrites ont été représentées schématiquement pour en dégager les fonctions essentielles. Dans la pratique, c'est-à-dire dans le circuit intégré réalisant ces fonctions, il est possible de répartir autrement les différentes moyens, par exemple en les imbriquant ou en les mélangeant. Ainsi, les registres de la partie 50 pourront être rapprochés des registres de la partie 60, pour faciliter la recopie des échantillons.

On peut également réaliser les circuits intégrés de telle manière que la spécification des coefficients du filtre n'intervienne que lors de la dernière opération de masquage. On peut ainsi réaliser très rapidement, à la demande, un filtre déterminé, à partir de circuits prédiffusés obtenus préablement.

**Revendications**

1. Multiplieur numérique généralisé apte à calculer une quantité P de la forme :

$$P = \sum_{i=0}^{N-1} a_i x_i$$

où les termes $a_i$ sont des mots binaires correspondant à N coefficients déterminés et les terms $x_i$ sont des mots binaires de B bits correspondant à N signaux variables, ce multiplieur numérique généralisé étant caractérisé par le fait qu'il comprend :

- N registres à décalage ($RD_0$, ..., $RD_{N-1}$) à entrée mot-parallèle sur les B bits et à sortie bits-série, le ième registre ($RD_i$) contenant les B bits du mot binaire $x_i$,

- N additionneurs conditionnels ($AdC_0$, ..., $AdC_{N-1}$) munis chacun d'une entrée de données, d'une sortie de données et d'une entrée de commande, l'entrée de commande ($ec_i$) du ième additionneur conditionnel ($AdC_i$) étant reliée à la sortie du ième registre à décalage ($RD_i$), l'entrée de données ($ed_i$) et la sortie de données ($sd_i$) du ième additionneur conditionnel ($AdC_i$) étant reliées respectivement à la sortie de données du (i-1)ième additionneur conditionnel et à l'entrée de données du (i+1)ième additionneur conditionnel, ledit ième additionneur conditionnel ($AdC_i$) incorporant le terme $a_i$ et ajoutant celui-ci au signal reçu sur son entrée de données, conditionnellement à la valeur du jième bit $x_{ij}$ du mot $x_i$, ce bit étant reçu sur l'entrée de commande ($ec_i$),

- un additionneur-accumulateur (AdAc) muni d'une première et d'une seconde entrées de données ($Ed_1$, $Ed_2$), la première entrée de données ($Ed_1$) étant reliée à la sortie ($sd_{N-1}$) du Nième additionneur conditionnel ($AdC_{N-1}$), ledit additionneur-accumulateur (AdAc) comprenant en outre une sortie de données (Sd) reliée à la seconde entrée de donnée ($Ed_2$) dudit additionneur-accumulateur (AdAc) après décalage d'une position des bits,

- un circuit d'horloge (H) pour commander en parallèle le décalage des B bits contenus dans les N registres série ($RD_0$, ..., $RD_{N-1}$) et faire passer le rang j de 0 à B-1,

- la quantité P recherchée étant délivrée sur la sortie de données (Sd) de l'additionneur-accumulateur (AdAc) tous les B coups d'horloge.

2. Multiplieur numérique selon la revendication 1, caractérisé par le fait que chaque additionneur conditionnel ($AdC_i$) est constitué par un additionneur ($Ad_i$) par une constante ($a_i$) et un multiplexeur ($MX_i$) à deux entrées de données ($e_i$, $e'_i$) reliées respectivement à l'entrée et à la sortie de l'additionneur ($Ad_i$) et à une entrée de commande ($Ec_i$) reliée à la sortie du registre à décalage de même rang ($RD_i$) et recevant un bit ($x_{ij}$).

3. Filtre numérique non récursif, mettant en oeuvre le multiplieur de la revendication 1, pour le calcul d'une expression de la forme :

$$P = \sum_{i=0}^{N-1} a_i x_{n-i}$$

caractérisé par le fait qu'il comprend :

- un registre d'entrée (50) à N registres ($REG_n$, ..., $REG_{n-N+1}$) de B Bits, chaque registre ayant une entrée parallèle sur B bits et une première sortie parallèle sur B bits, ces registres étant reliés les uns aux autres en parallèle par ces entrées-sorties parallèles, chaque registre ayant en outre une seconde sortie parallèle,

- un multiplieur numérique conforme à la revendication 1, avec un ensemble (60) de registres à décalage ($RD_0$, ..., $RD_{N-1}$) et une batterie (70) d'additionneurs conditionnels ($AdC_0$, ..., $AdC_{N-1}$), dans lequel l'entrée mot-parallèle du ième registre à décalage ($RD_i$) est reliée à la seconde sortie du registre de même rang i ($REG_i$).

4. Filtre numérique selon la revendication 3, caractérisé par le fait que le registre d'entrée (50) travaille à une fréquence de signal $f_s$, l'ensemble (60) de N registres à décalage ($RD_0$, ..., $RD_{N-1}$) recopie le contenu du registre d'entrée (50) à une fréquence $f_r$, et la batterie (70) d'additionneurs conditionnels ($AdC_0$, ..., $AdC_{N-1}$) à une fréquence de calcul $f_c$.

5. Filtre numérique selon la revendication 4, caractérisé par le fait que $f_r = f_s$ et $f_c = Bf_s$.

6. Filtre numérique selon la revendication 4, caractérisé par le fait qu'il travaille en sous-échantillonnage d'un facteur M, et que $f_r = f_s/M$ et $f_c = Bf_s/M$.

7. Filtre numérique caractérisé en ce qu'il comprend L filtres ($F_1$, $F_2$, etc.) et conformes à la revendication 6, ces L filtres fonctionnant en parallèle et recevant sur une entrée commune (E) les mêmes échantillons ($x_n$, $x_{n-1}$, ...) à la fréquence de signal $f_s$, chaque filtre ne recopiant ces échantillons qu'à la fréquence $f_r = f_s/L$ à des instants différents d'un filtre au suivant et décalés de $T_s/L$, où $T_s$ désigne la période correspondant à la fréquence $f_s$, les sorties de ces L filtres étant réunies en une seule sortie constituant la sortie du filtre (5).

9

EP 0 327 445 A1

FIG. 1

$$a_{N-1}, a_i, a_2, a_1, a_0$$

$$x_{N-1} \quad x_i \quad x_2 \quad x_1 \quad x_0$$

14

20 24

.10.

12

16

.18.

22

P

FIG. 2

R0   $x_{0,0}$   $x_{0,B-2}$ $x_{0,B-1}$   E1

R1   $x_{1,0}$   $x_{1,B-2}$ $x_{1,B-1}$   E2

Ri   $x_{i,0}$   $x_{i,B-2}$ $x_{i,B-1}$   Ei

$R_{N-1}$   $x_{N-1,0}$   $x_{N-1,B-2}$ $x_{N-1,B-1}$   $E_{N-1}$

B

.30.

S

37

35

.34.

36

P

EP 0 327 445 A1

FIG. 3

FIG. 4

FIG. 5

FIG. 6

FIG. 7a

FIG. 7b

FIG. 8a

FIG. 8b

FIG 9

$$S_i$$

$$Ad_i \quad | \quad (a_i)$$

$$e_i \qquad e_i'$$

$$X_i \longrightarrow \quad M \; X_i$$

$$ec_i \qquad \lambda i$$

$$S_{i+1} \qquad \Big\} Ad C_i$$

## FIG. 10

$$0$$

$$+ a_0 \qquad | \quad U_0 \qquad Ad C_0$$

$$+ a_1 \qquad | \quad U_1 \qquad Ad C_1$$

$$+ a_2 \qquad | \quad U_i \qquad Ad C_i$$

$$+ a_{N-1} \qquad | \quad U_{N-1} \qquad Ad C_{N-1}$$

## FIG. 11

$$F_j$$

FIG. 12

FIG. 13

FIG. 14

EP 0 327 445 A1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | EP-A-0 078 101  (ITT)<br>* Page 1, ligne 1 - page 5, ligne 4; figures 1,2 *<br>--- | 1,3 | G 06 F    7/544<br>H 03 H   17/02 |
| A | EP-A-0 253 475  (INMOS)<br>* Page 3, ligne 9 - page 4, ligne 56; figures 1,2 *<br>----- | 1,3 | |

**DOMAINES TECHNIQUES
RECHERCHES (Int. Cl.4)**

G 06 F    7/00
H 03 H   17/00

Le présent rapport a été établi pour toutes les revendications

| Lieu de la recherche | Date d'achèvement de la recherche | Examinateur |
|---|---|---|
| LA HAYE | 14-03-1989 | NUSSBAUMER C.P. |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons
........................................................................
& : membre de la même famille, document correspondant

EPO FORM 1503 03.82 (P0402)